# EUROPEAN PATENT APPLICATION

(11) **EP 3 961 518 A1**
(43) Date of publication of application: **02.03.2022**
(21) Application number: 20192534.4
(22) Date of filing: 25.08.2020
(51) Int. Cl.: G06N 20/00, G03F 7/20, G03F 9/00

(54) **METHOD AND APPARATUS FOR CONCEPT DRIFT MITIGATION**

(71) Applicant: ASML Netherlands B.V., 5500 AH Veldhoven (NL)
(72) Inventor: KOULIERAKIS, Eleftherios, 5500 AH Veldhoven (NL); LANCIA, Carlo, 5500 AH Veldhoven (NL); GONZALEZ HUESCA, Juan Manuel, 5500 AH Veldhoven (NL); YPMA, Alexander, 5500 AH Veldhoven (NL)
(74) Representative: ASML Netherlands B.V.

(57) **Abstract**

Method and apparatus for adapting a distribution model of a machine learning fabric. The distribution model is for mitigating the effect of concept drift, and is configured to provide an output as input to a functional model of the machine learning fabric. The functional model is for performing a machine learning task. The method comprises obtaining a first data point, and providing the first data point as input to one or more distribution monitoring components of the distribution model. The one or more distribution monitoring components have been trained on a plurality of further data points. A metric representing a correspondence between the first data point and the plurality of further data points is determined, by at least one of the one or more distribution monitoring components. Based on the error metric, the output of the distribution model is adapted.

## Description

### FIELD

The invention relates to methods and apparatus for detecting and/or mitigating effects of concept drift for machine learning models. In particular the invention relates to adapting a distribution model configured to provide an output to a functional model for performing a machine learning task.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-kl lithography may be used to process features with dimensions smaller than the classical resolution limit of a lithographic apparatus. In such process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

A lithographic apparatus may have metrology tools such as metrology apparatus and inspection apparatus associated with it for measuring characteristics of the lithographic apparatus and the substrates patterned by the lithographic apparatus. The metrology and inspection apparatus may measure and obtain data in relation to the lithographic apparatus, substrates, and/or patterns.

It is known that the properties and behaviours of a lithographic apparatus and/or a metrology apparatus can change over time. This may lead to a phenomenon known as concept drift in machine learning systems used for predictive analytics and/or monitoring of a lithographic apparatus and/or metrology tool. Concept drift may occur as a result of changes in the lithographic apparatus itself, and/or may be caused by changes in the metrology tools.

Concept drift poses a challenge for machine learning models related to the lithographic system. Such models may be related to the lithographic patterning process, and are often trained on data relating to the lithographic apparatus, including data obtained by the metrology tools. Concept drift may reduce the performance of models and may render them obsolete, as the characteristics and properties of the system move away from those the model was trained on.

### SUMMARY

It is an object of the present invention to provide a method for adapting a distribution model of a machine learning fabric. The distribution model may be for mitigating the effect of concept drift. The distribution model may be configured to provide an output as input to a functional model of the machine learning fabric. The functional model may be for performing a machine learning task. The method comprises obtaining a first data point, providing the first data point as input to one or more distribution monitoring components of the distribution model. The one or more distribution monitoring components have been trained on a plurality of further data points. A metric representing a correspondence between the first data point and the plurality of further data points is determined by at least one of the one or more distribution monitoring components. Based on the error metric, the output of the distribution model is adapted.

Optionally, adapting the output of the distribution model may comprise, if the metric determined by the at least one distribution monitoring component exceeds a drift threshold, generating a training distribution monitoring component associated with the data point.

Optionally, the method may further comprise training the training distribution monitoring component on subsequent data points for which the metric determined by the at least one distribution monitoring component exceeds the drift threshold.

Optionally, the training distribution monitoring component may be configured to determine a further metric. The training of the training distribution monitoring component may be complete when the further metric is below a training threshold.

Optionally, the method may further comprise adding the training distribution monitoring component to the one or more distribution monitoring components of the machine learning fabric after completion of the training.

Optionally, adapting the output of the distribution model may comprise outputting a weighted combination of two or more distribution monitoring components.

Optionally, the weighted combination may comprise a weighted average inversely proportional to the metric of the two or more distribution monitoring components.

Optionally, the output of the distribution model may take into account the distribution model output of one or more previous data points of the plurality of data points.

Optionally, the distribution monitoring component may comprise a machine learning algorithm that outputs a metric that reflects how well a data point matches a known data distribution associated with the distribution monitoring component.

Optionally, the metric may comprise a measure of a correlation between the first data point and a reconstruction of the first data point generated by the one or more distribution monitoring components.

Optionally, the one or more distribution monitoring components may comprise one or more of an autoencoder, a variational autoencoder, an isolation forest, a one-class support vector machine, and wherein the metric comprises a reconstruction error.

Optionally, the functional model may comprise one or more functional components, configured to undertake the machine learning task.

Optionally, the one or more functional components may be linked to the one or more distribution monitoring components. The output of the distribution model may comprise an instruction of one or more functional components to be used when undertaking the machine learning task.

Optionally, he output of the distribution model may instruct the functional model to use a weighted combination of two or more functional components.

Optionally, the method may further comprise generating a new functional component of the machine learning fabric, based on the added distribution monitoring component.

Optionally, the first data point and/or the plurality of further data points may be associated with a lithographic process.

Optionally, the machine learning task may comprise performing predictive maintenance associated with a lithographic process.

Optionally, the machine learning task may comprise a performance classification.

Optionally, the data point may have a missing value. The method may further comprise determining, based on the metric, a value to fill the missing value, and adding the determined value to the data point.

According to another aspect of the current disclosure, there is provided an apparatus comprising one or more processors and a non-transitory storage medium storing instructions which cause the one or more processors to control the apparatus to perform a method as set out above.

According to another aspect of the current disclosure there is provided an inspection apparatus comprising the apparatus described above.

According to another aspect of the current disclosure there is provided a metrology apparatus comprising the apparatus described above.

According to another aspect of the current disclosure there is provided a lithographic apparatus comprising the apparatus described above.

According to another aspect of the current disclosure there is provided a lithographic cell comprising the lithographic apparatus described above.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a graph showing example styles of concept drift;
- Figure 5 depicts a flow diagram of steps in a method for adapting a distribution model of a machine learning fabric;
- Figure 6 depicts a flow diagram of steps in a method of a distribution model receiving and processed a data point according to an example implementation;
- Figure 7 depicts a flow diagram of steps in a method for performing a machine learning task mitigating an effect of concept drift; and
- Figure 8 depicts a graph of a schematic example of concept drift in a data set over time.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

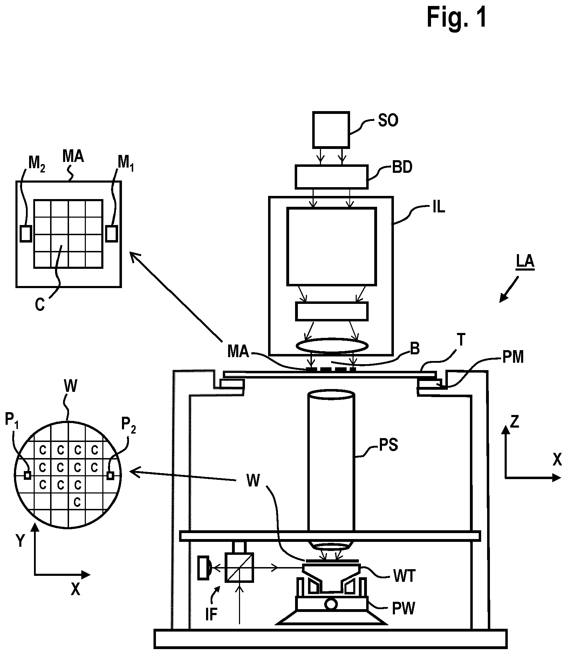

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

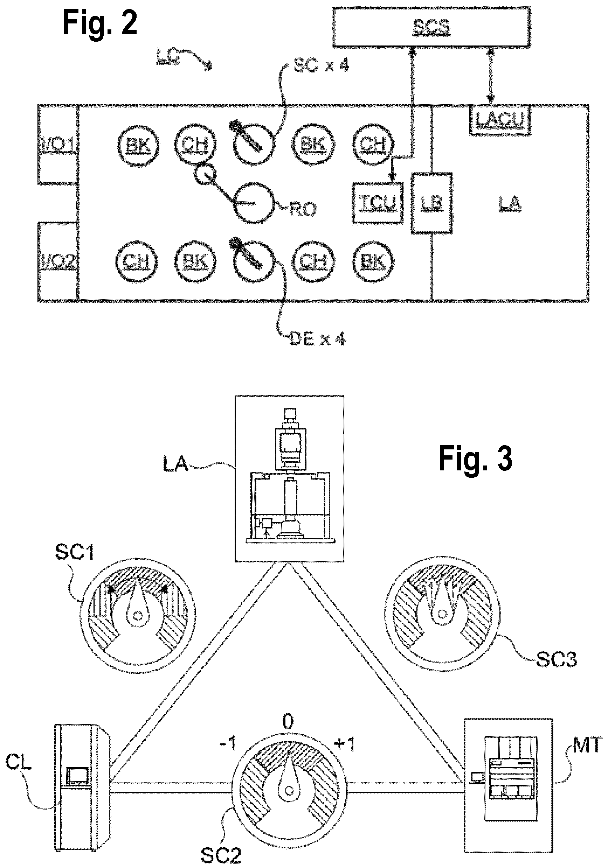

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

The lithographic apparatus LA is used to pattern substrates. Metrology tool MT may be used to monitor the patterning process, and inspect the patterned substrates. Models, for example machine learning models, may be used to process data associated with a lithographic process, e.g. data related to a lithographic apparatus and/or related metrology tools MT, which may be termed lithographic data. For example, the models may be used for analysis of the apparatus, patterning process recipe settings, inspection of patterned substrates fabricated using the lithographic apparatus LA etc. By processing the lithographic data, models may perform functions including suggesting updates to process settings, predicting future behaviour of the whole or parts of the process (e.g. for predictive maintenance), monitoring the apparatus performance, etc. In order to provide these functions, a model may be built based on knowledge about the lithographic process. For example, a model may be trained using lithographic data, which may comprise data from the metrology tool and/or data from the lithographic apparatus LA. The lithographic data may be gathered by the lithographic apparatus LA and metrology tools MT relating to the lithographic process, the substrates, and deposited patterns.

One challenge concerning lithographic data is concept drift. Concept drift in this context may be understood to comprise gradual and/or sudden changes to the lithographic data as a result of changes in a part of the lithographic process. Concept drift may originate in the lithographic apparatus LA itself, for example due to wear of components inside, or changes in the conditions inside the apparatus (e.g. temperature pressure). Concept drift may also occur as a result of differences between substrates, for example differences between different lots of wafers, differences in deposited layers for exposure. Other example reasons for changes in lithographic data may include wear or changes in conditions of a metrology tool MT, errors, hardware changes (e.g. replacement components), software and settings changes (e.g. patterning recipe updates/adjustments, etc.) Concept drift may result in the obtained lithographic data diverging from the data and information on which a model was built. When concept drift takes place, the performance of a model may decrease, because the structure of the data is different from the structure of the data on which the model was trained and/or designed. This means that the model performance may decrease over time and the model may become obsolete.

It is noted that the specific example provided herein is of a machine learning system used in monitoring a lithographic process. However, this is only one specific arrangement and the invention need not be limited to this example. In some arrangements, the invention may be used in other contexts for monitoring other systems.

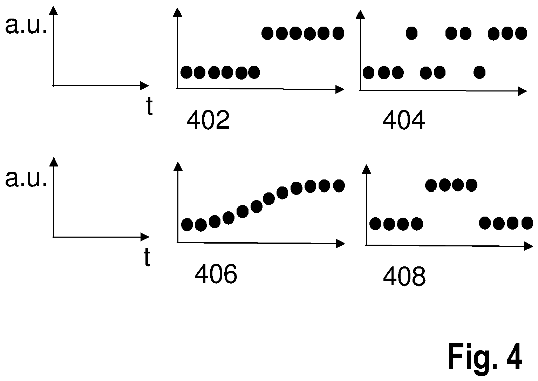

Figure 4 depicts a schematic representation of example styles of concept drift in data. The x-axis shows time and the y-axis shows data points in arbitrary units (a.u.) for different types of concept drift in four graphs 402, 404, 406 and 408.

Graph 402 shows sudden drift, in which there is a sudden change in data from a first distribution, represented by the first six data points, to a second distribution, represented by the last six data points. As the name suggests, the change is sudden and may occur at a single point in time. The first and second distributions may be clearly separated from each other and there may be little or no blend or overlap between the two distributions.

Graph 404 shows gradual drift, in which there may be two clearly separated distributions. The data may experience a gradual move from the first to the second distribution by having a period of time wherein data points of both separate distributions occur. As time passes, the proportion of second distribution data points increases as the proportion of first distribution data points decreases.

In graph 406 incremental drift is illustrated. In this type of concept drift, the shift between distributions is not discrete, and data may incrementally evolve towards a different, second distribution.

Graph 408 shows recurring drift, in which data may move between two (or more) distributions multiple times. For example, data points may move from a first distribution to a second distribution at a first point in time. The data points may move back from the second distribution to the first distribution at a second point in time. It will be understood that combinations and variations of the examples shown in graphs 402 - 408 may occur. Concept drift is not limited to two distributions, and third, fourth, fifth, etc. distributions may also occur.

The example distributions illustrated in figure 4 may represent different types of concept drift that may occur in a system, such as a lithographic apparatus LA. For example, incremental drift 406 may represent for example gradual wear over time of one or more components in the apparatus, or a change in operating conditions (e.g. temperature, pressure). A sudden drift as illustrated in 402 may represent a sudden change, either intentional or unintentional. For example, a sudden drift may be the result of a change in wafer lot, a change in reticle design, a change in recipe settings, a change in the patterning process outside the lithographic exposure step, the introduction of a new/replacement component in the machine, or a sudden breakage in the machine. A gradual drift 404 may for example be an indication of a failure of a component, wherein some data points correspond to a distribution representing a failure state of the component, and some data points correspond to a distribution representing a nominal state.

It has been suggested to implicitly deal with concept drift by training and retraining a model periodically using a set time window. However, this may be time and/or computation intensive. This method may have a further disadvantage of relying on a set time window that is independent of any occurrence of concept drift itself. As concept drift is an unintended phenomenon, it may be difficult to predict when and/or how it will occur. If the time window set for updating a model is too large compared to concept drift changes, the updates will not accurately capture the data drift, and the model performance will be unreliable and negatively affected by concept drift.

Described herein are methods and apparatus for detecting concept drift in a data set. The methods and apparatus may be arranged to adapt a model of a machine learning fabric. The model may be referred to as a distribution model. The distribution model may further be used to inform and guide one or more other, functional, models that use the data set for performing a task or function. The task may be a machine learning task. Specifically, the distribution model may provide information and guidance to the one or more functional models on how to deal with a detected concept drift. The machine learning fabric therefore comprises one or more distribution models and one or more functional models. The functional model(s) may be configured to receive and process a plurality of data points forming the data set. The machine learning fabric may be configured to process the received data points using the distribution model before passing the data points to the functional model. The processing of the data points using the distribution model may allow the machine learning fabric to provide information regarding concept drift to the functional model, alongside the data points.

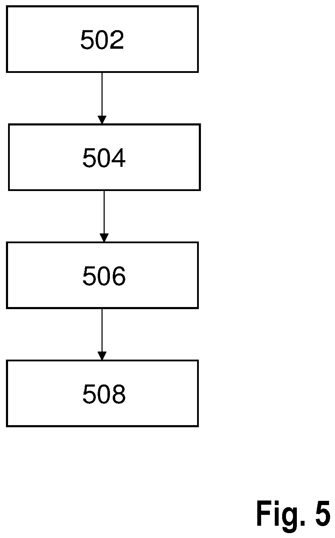

Figure 5 depicts a flow diagram of a method for adapting a distribution model of a machine learning fabric. A machine learning fabric may be understood as a system of software and optionally hardware, comprising at least one machine learning model. In exemplary arrangements disclosed herein, the machine learning fabric includes a distribution model and a functional model. The distribution model may be for mitigating effects of concept drift. The distribution model is configured to provide an output to the functional model. The output provided as an input to the functional model may assist the functional model in mitigating the effect of concept drift. The functional model is for performing a machine learning task. In step 502 a first data point is obtained. In step 504 the first data point may be provided as input to one or more distribution monitoring components of the distribution model. The one or more distribution monitoring components have been trained on a plurality of further data points. In step 506, at least one of the one or more distribution monitoring components determines a metric representing a correspondence between the first data point and the plurality of further data points on which the distribution monitoring component has been trained. In step 508 the output of the distribution is adapted, based on the metric. Adapting the output of the distribution model may involve adapting the distribution model itself, for example the architecture of the distribution model. Adapting the output of the distribution model may involve adapting the values output by the distribution model.

An advantage of the method described above, is that a distribution model may be used to detect and monitor concept drift, and may feed this information to a functional model so that steps can be taken for the functional model to mitigate the effects of concept drift. As concept drift occurs, the method allows the distribution model to adapt itself to deal with the concept drift. For example, the distribution model may create a further distribution monitoring component, which may be trained on subsequent data points.

The machine learning fabric may comprise further elements, for example one or more of models, databases, tables, etc. The machine learning fabric may be a system intended to perform a machine learning task related to a lithographic apparatus LA or holistic lithographic system.

As described in relation to Figure 4 above, concept drift may represent data points, and their associated systems, moving between different distributions. The distribution model may detect concept drift by receiving a data point, and comparing it to further data points, which may have been obtained previously. A plurality of previous further data points may be used to build up a picture of expected behaviour (a distribution) for the data points when not exhibiting concept drift. Once the system has obtained an idea of expected data point behaviour, it can use a comparison of a new data point to this expected behaviour to determine whether concept drift has occurred. The expected behaviour can be associated with a data point distribution. It is possible for different expected behaviours to be identified as different distributions.

In order to achieve a comparison of a data point to expected data behaviours, the distribution model may comprise one or more distribution monitoring components. Each component may be configured to recognize a previously identified distribution associated with an expected behaviour. A data point may be provided to each of the one or more distribution monitoring components of the distribution model. Each distribution monitoring component may provide an output indicating whether and/or how well the data point matches the distribution. In one example implementation, if one of the distribution monitoring components finds that a received data point matches a previously identified distribution, it may classify that data point as belonging to the matching distribution. If none of the one or more distribution monitoring components recognize a received data point as forming part of their distribution, this may indicate a concept drift of the data to a new distribution. In another example implementation, each of the one or more distribution monitoring components may provide an output comprising an indication of the similarity of the data point to its distribution.

The output from the distribution monitoring component(s) about the data point comparison to previously identified distribution(s) may be output by the distribution model and provided to the functional model. Alternatively, the outputs of the distribution model components may be processed before being output by the distribution model itself. This processing may additionally or alternatively be performed by an element in the machine learning fabric after the output has been provided by the distribution model. Processing may for example comprise determining a representation of the similarity of the data point to the one or more distributions. This representation may be used as a measure of concept drift. The output of the distribution model, optionally in processed form, may be provided to the functional model. The output may be provided alongside the data point itself, so that the functional model receives the data point and an indication of concept drift of the data point.

The metric for the data point and determined by the one or more distribution models may comprise multiple metric components. For example, each distribution monitoring component may have an associated metric component. The metric components may represent a measure of how well a data point matches the previously identified data distribution associated with the corresponding distribution monitoring component. A metric component may be determined for each of the distribution monitoring components. The metric components may be assessed against a drift threshold. The drift threshold may be set by a user of the system and/or may be determined by the distribution monitoring component, for example based on the determined distribution. The drift threshold may be the same for each metric component. Alternatively, a different drift threshold may be set independently for one or more separate distribution monitoring components. If the metric exceeds the threshold, for example if each metric component exceeds its associated drift threshold, this may be seen as an indication of concept drift. If the data point matches none of the identified distributions, this data point may be considered a change point. In response to the detection of a change point, a training distribution monitoring component may be generated associated with the data point.

A training distribution monitoring component may be trained before it may be added to the distribution model. Training data may be obtained by processing further data points, and selecting those of the further data points for which the metric exceeds the drift threshold. The data points not matching to any of the existing distributions may be added to the training set of the training distribution monitoring component. This training set may be used for training the training distribution monitoring component. The training distribution monitoring component may have the same form as the one or more distribution monitoring components already forming part of the distribution model. The training distribution monitoring component may be configured to determine a metric component. The training may be determined to be complete once the output of the training distribution monitoring component falls below a training threshold. In exemplary arrangements, training may be determined to be complete when the output of the training distribution monitoring component falls below the training threshold at least a certain number of times and/or at least a certain percentage of times. Once the training of the training distribution monitoring component has been completed, it may be added as a distribution monitoring component to the distribution model. Subsequent data points may be provided as input to the added distribution monitoring component. This process of identifying, training, and adding a new distribution monitoring component may form part of the method of adapting the output of the distribution model.

Between the initial detection of the concept drift and adding the new distribution monitoring component to the distribution model, the distribution model may use a weighted average of existing distribution monitoring components to classify the data points. The classification of data points in this way may be output from the distribution model to the functional model for use in undertaking the machine learning task. Alternatively or additionally, the training distribution monitoring component may be used to determine an output, even before training is complete. If the output of the training distribution monitoring component is better than the obtained results from the distribution monitoring component(s) already forming part of the distribution model, the output from the training distribution monitoring component may be used in addition to or as an alternative to the outputs from the distribution monitoring component(s).

As described above, the metric determined by the distribution model may comprise a metric component for each of the one or more distribution monitoring components of the distribution model. The metric and/or the metric component(s) may represent a measure of similarity of the data point to the data distribution associated with the distribution monitoring component. A metric component may for example comprise an error metric, representing an error, or lack of similarity, between the received data point and the expected behaviour of the distribution associated with the distribution monitoring component.

The output of the distribution model may comprise an indication of the similarity of the data point to each of the one or more distribution monitoring components. The output may for example comprise a weighted combination of the one or more distribution monitoring components. The weights may represent the similarity of the data point to the associated distribution. The combination may be a weighted average related to the metric components. For example, the weighted average may be inversely proportional to an error metric determined by the distribution monitoring components.

A distribution monitoring component may be configured to generate a reconstruction of a received data point. The metric and/or metric components may comprise a measure of correlation between the data point, and the generated reconstruction. A distribution monitoring component may for example comprise an autoencoder (AE). The distribution monitoring component may alternatively or additionally comprise a variational autoencoder, an isolation forest, a one-class support vector machine, or any other algorithm that outputs a metric component reflecting how well a received data point matches the associated data distribution. An autoencoder, or variation thereon, may be configured to determine a reconstruction of a received data point. The autoencoder may then determine a reconstruction error indicating a difference between the data point and the reconstruction of the data point. This reconstruction error may be the metric component determined by the autoencoder. An autoencoder may be trained to reconstruct data points of a specific distribution, that is to say, data points that may have some similarities or a shared structure. For data points that move away from these similarities and structure, for example as a result of concept drift, the reconstruction will not be as effective and the reconstruction error may be greater. Therefore, the larger the reconstruction error, the further removed the data point from the associated distribution.

The distribution model may process each data point individually, separate from other data points. Alternatively, the distribution model may take into account one or more (immediately) preceding data points, for example to detect trends or identify a type of concept drift, e.g. gradual concept drift, incremental concept drift.

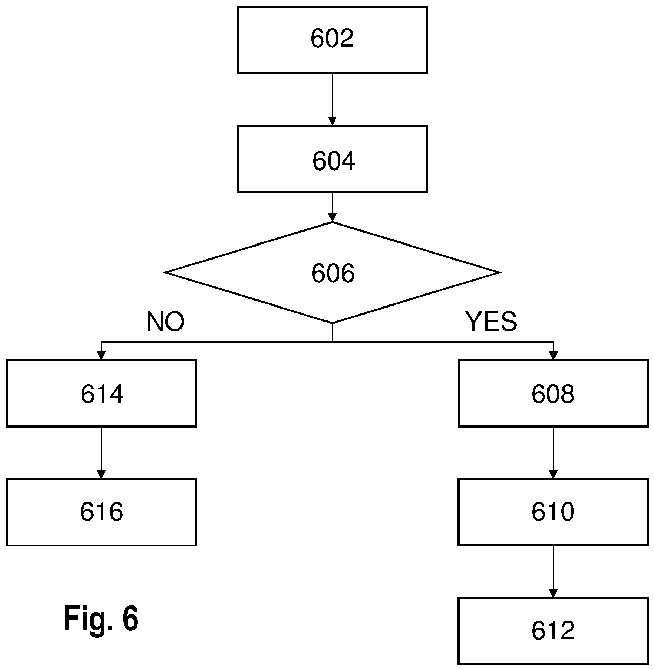

Figure 6 depicts a flow diagram of steps in an example implemented method of a distribution model receiving and processing a data point. The flow diagram illustrates different ways in which the output of the distribution model may be adapted, depending on the analysis of the data point by the distribution model. In step 602 a data point may be received as input to a distribution model. In step 604, the data point may be processed by the distribution model. As part of the processing, each of the one or more distribution monitoring components may determine whether the data point matches the data distribution associated with that distribution monitoring component. In step 606 the method may determine whether a change point is detected, which matches none of the existing data distributions. If that is the case, the method may move to step 608 in which a new training distribution monitoring component is generated. The training distribution monitoring component may be trained in step 610, as described in more detail above. Once trained, the new distribution monitoring component may be added to the distribution monitoring components of the distribution model in step 612.

However, if in step 606 the distribution model concludes that no change point has been detected, the method may move to the monitoring phase in step 614. Adapting the output in this case does not involve adding a new distribution monitoring component. Instead, the output may be adapted by determining, in step 616, a weighted combination and/or a selection for some or all of the distribution monitoring components representing how well the data point matched an associated distribution.

Until the training 610 and adding 612 of the new distribution monitoring component have been completed, the distribution mode may also apply steps 614 and 616 to the data point identified as a change point. Alternatively or additionally, an output may be determined by the training distribution monitoring component before training is complete. This output may be added to the weighted combination determined in step 616.

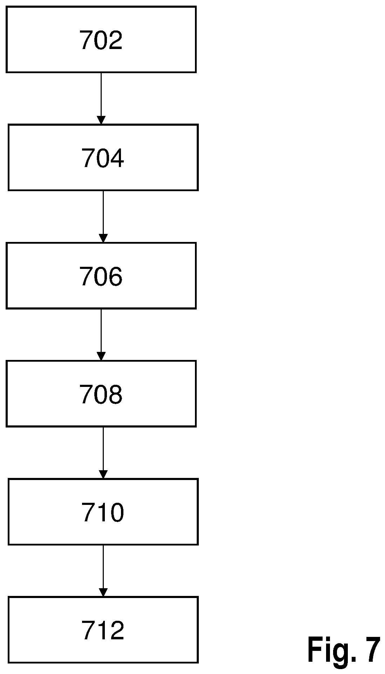

Once the distribution model has determined a metric, the output of the model may be adapted by generating and creating a new distribution monitoring component and/or by determining a weighted combination of two or more of the distribution monitoring components. This output may be provided to the functional model. Figure 7 depicts a flow diagram of a method in which steps 702 - 708 correspond to steps 502 - 508 of figure 5, leading to adapting the output of the distribution model. Once the distribution model output has been adapted based on the assessment of concept drift of the data point, in step 710 the adapted output may be provided to the functional model. The data point may also be provided to the functional model in step 710. In step 712, the functional model may use the received data point and distribution model output to perform the machine learning task.

The functional model may comprise one or more functional components. The functional components may be configured to undertake the machine learning task. The functional components may be linked to one or more of the distribution monitoring components. In an example implementation each of the functional components may have a corresponding distribution monitoring component. The functional components may have been configured, e.g. trained, to process data points matching the data distribution of the corresponding distribution monitoring component. The functional model may comprise one or more random forests. For example, each functional component may comprise a random forest trained on a different data distribution.

If a new training distribution monitoring component is generated, the functional model may be informed of this via the output of the distribution model. In response, the functional model may generate a corresponding new training functional component. The new training functional component may be trained on the training data set gathered by the distribution model. The training may be performed using one or more training methods known in the art. The training functional component may be generated and trained to be configured to perform the machine learning task using data of the newly identified data distribution. Once the training has been completed, the training functional component may be added as a new functional component to the functional model.

The functional model may perform the machine learning task using one or more functional components. As described above, the distribution model may provide as output a weighted combination of two or more distribution monitoring components. The functional model may determine the machine learning task using a combination of corresponding functional components in the same weighted combination. In another example implementation, the functional model may make a selection of functional components based on the received weighted combination. The functional model may for example discard components with a weight below a predetermined relevance threshold. The functional model may for example select functional components with weights above a predetermined relevance threshold. In another example, the functional model may in some instances select a single functional component. This may for example be done by determining the extent of dominance of the functional component with the largest weight, e.g. by determining the size of largest weight compared to the other weights in the combination. If the extent of dominance is above a predetermined dominance threshold, the functional model may determine to perform the machine learning task using the functional component corresponding to the dominant weight. Limiting the amount of functional components used may have an advantage of reducing computational and/or time cost for performing the machine learning task. The thresholds mentioned above may be set for example by a user of the machine learning fabric.

An advantage of the methods and systems described herein may be that the machine learning fabric is self-adapting. That is to say, the machine learning fabric may be able to detect concept drift and adapt the functioning of the machine learning fabric to mitigate the effect of the detected drift. The adaptation of the distribution model and the functional model result from the regular operation of the machine learning fabric described herein, and no further interference is needed for the systems to adapt to mitigate the effects of different types of detected concept drift. The self-adapting of the system may allow the machine learning fabric to handle unexpected and/or previously unseen behaviour in the data points.

A further advantage of the methods and systems described herein may be the smart allocation of modelling tasks. The performance of a machine learning model may depend on the data set on which it has been trained and tested. A machine learning model such as a functional model may perform better when receiving as input a data point similar to the data points on which it has been trained. Similar data points in this instance may be understood as belonging to the same distribution.

Machine learning fabrics disclosed herein may be used in a data pre-processing step. One part of data pre-processing is related to resolving issues with missing values in a data set. For example, a data point may comprise a plurality of data values relating to a process, such as a lithographic process. The distribution model and/or the functional model may expect every value to be present in every data point. The machine learning model may not be able to handle data points where some of the values are missing. An example way of dealing with missing values may be to fill the missing value with a value equal to the mean, mode, or median of the dataset for that value. This solution does not take into account concept drift, or the possible presence of multiple different data distributions. The machine learning fabric could be used to replace one or more missing values of a data point based on a data set of the distribution to which the data point belongs. Instead of imputing the mean, mode, or median of the entire data set, a mean, mode, or median may be imputed based on a weighted combination of different data distributions. This determination of one or more missing data values may be performed by the distribution model of a machine learning fabric.

The methods and systems described above may relate to machine learning tasks performed using data sets in which concept drift may occur. The data may relate to a process or apparatus. An example will now be described in more detail, relating to a lithographic patterning process. Each data point may comprise a plurality of data values relating to the lithographic process. Examples of data values may include measurement values of overlay, alignment, levelling, dose, focus, critical dimension, temperature, pressure, etc. All the values in a data point may be related, for example to the same substrate, the same exposure performed on a substrate, etc. Different data points may relate to different substrates, exposure layers, etc.

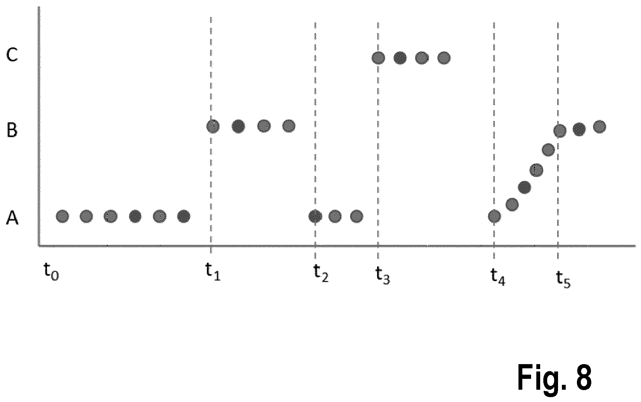

Figure 8 is a graph depicting a schematic example of concept drift in a data set over time, to illustrate the method and functioning of the machine learning fabric. We pick up the data set at time to.At t0, a machine learning fabric as described herein and is ready for use. The distribution model comprises one trained distribution monitoring component A for determining a correlation to data distribution A. Distribution A also has associated trained functional component A of the functional model. The distribution monitoring component A may be configured to identify data points belonging to data distribution A. The functional component A may have been trained on a training data set comprising only data points belonging to data distribution A.

From time t₀ until t₁, all received data points are identified to belong to distribution A. At time t1 a data point is received that does not belong to data distribution A, due to sudden concept drift. The mis-match of the data point to distribution A is identified by the distribution model. For example, the distribution monitoring component may be an autoencoder that generates a large error when reconstructing the received data point. A new data distribution B is identified. A training distribution monitoring component B is generated. Further data points from distribution B are identified (e.g. data points that do not fit distribution A) and added to a training set for training the training distribution monitoring component B. Once trained, distribution monitoring component B may be added to the distribution model, which now comprises two distribution monitoring components A and B. In addition, a new functional component B may be generated, trained on data points belonging to data distribution B, and added to the functional model. Once trained, distribution monitoring component B may identify data points belonging to data distribution B in the period between t₁ and t₂.

In the period between t₂ and t₃, data points belonging to data distribution A may be identified by distribution monitoring component A. At time t₃, a new sudden concept drift occurs. This may be identified because neither autoencoder A nor B is able to accurately reconstruct the data point. A new distribution monitoring component C is generated and trained, similar to distribution monitoring component B above. An associated functional component C may be generated, trained, and added to the functional model as well.

In the period between t₄ and t₅ an incremental concept drift from data distribution A to B takes place. Both distributions A and B may have been discovered already. The corresponding distribution monitoring components A and B may have had their training completed. The distribution monitoring components for A and B may provide an output indicating how the data distribution of each data point incrementally changed from A to B. During all periods t₀ - t₅, a weighted combination of the existing functional models may be used to perform the machine learning task. The weighting of the functional components may be inversely proportional to the reconstruction error of the corresponding autoencoders. If, during an incremental drift, the data points converge to a distribution that does not match an existing, known distribution, this may indicate that the data points have incrementally drifted to a new distribution. This may be indicated by the data points having a poor matching metric to all of the existing data distributions, and wherein the metric may be stable over time. This may lead the distribution model to train and add a new distribution monitoring component.

The methods and machine learning fabric may be used for any type of task impacted by concept drift. The task may be a machine learning task related to a lithographic processes. Example processes may relate to substrate inspection and/or apparatus monitoring. A first example task may relate to a quality assessment of lithographically patterned substrates. The task may for example comprise a classification of substrates based on patterning quality. The functional model may be configured to perform a method for making a decision within a lithographic manufacturing process. The decision may for example be to approve or discard the substrate, to change future patterning settings, etc. The functional model may have been trained using one or more of machine learning (e.g. neural network, random forest, deep learning), optimization, regression, or statistical techniques. The data point may comprise values relating to one or more of overlay, focus, critical dimension, critical dimension uniformity, thermal data, pressure data, an/or other environmental data of the lithographic apparatus LA during patterning of the substrate, etc.

Another example task may relate to predictive maintenance, in which the status of an apparatus may be monitored. Monitoring the status may be used to try to predict what type of maintenance should be performed and when, for example to reduce apparatus downtime, failure of the apparatus and/or reduction of patterning quality. The status of an apparatus may be monitored using metrology data relating to the apparatus itself and/or metrology data of the substrates patterned by the apparatus.

Further embodiments are disclosed in the list of numbered clauses below:
1. A method for adapting a distribution model of a machine learning fabric, the distribution model for mitigating the effect of concept drift, the distribution model configured to provide an output as input to a functional model of the machine learning fabric, the functional model for performing a machine learning task, the method comprising:
   obtaining a first data point;
   providing the first data point as input to one or more distribution monitoring components of the distribution model, wherein the one or more distribution monitoring components have been trained on a plurality of further data points;
   determining, by at least one of the one or more distribution monitoring components, a metric representing a correspondence between the first data point and the plurality of further data points; and
   based on the error metric, adapting the output of the distribution model.
2. A method according to clause 1, wherein adapting the output of the distribution model comprises, if the metric determined by the at least one distribution monitoring component exceeds a drift threshold, generating a training distribution monitoring component associated with the data point.
3. A method according to clause 2, further comprising training the training distribution monitoring component on subsequent data points for which the metric determined by the at least one distribution monitoring component exceeds the drift threshold.
4. A method according to clause 3, wherein the training distribution monitoring component is configured to determine a further metric, and wherein the training of the training distribution monitoring component is complete when the further metric is below a training threshold.
5. A method according to clause 3 or 4, further comprising adding the training distribution monitoring component to the one or more distribution monitoring components of the machine learning fabric after completion of the training.
6. A method according to any preceding clause, wherein adapting the output of the distribution model comprises, outputting a weighted combination of two or more distribution monitoring components.
7. A method according to clause 6, wherein the weighted combination comprises a weighted average inversely proportional to the metric of the two or more distribution monitoring components.
8. A method according to any preceding clause, wherein the output of the distribution model takes into account the distribution model output of one or more previous data points of the plurality of data points.
9. A method according to any preceding clause, wherein the distribution monitoring component comprises a machine learning algorithm that outputs a metric that reflects how well a data point matches a known data distribution associated with the distribution monitoring component.
10. A method according to any preceding clause, wherein the metric comprises a measure of a correlation between the first data point and a reconstruction of the first data point generated by the one or more distribution monitoring components.
11. A method according to clause 9 or 10, wherein the one or more distribution monitoring components comprise one or more of an autoencoder, a variational autoencoder, an isolation forest, a one-class support vector machine, and wherein the metric comprises a reconstruction error.
12. A method according to any preceding clause, wherein the functional model comprises one or more functional components, configured to undertake the machine learning task.
13. A method according to clause 12, wherein the one or more functional components are linked to the one or more distribution monitoring components, and wherein the output of the distribution model comprises an instruction of one or more functional components to be used when undertaking the machine learning task.
14. A method according to any of clauses 12 to 13, wherein the output of the distribution model instructs the functional model to use a weighted combination of two or more functional components.
15. A method according to any of clauses 12 to 14, when dependent on clause 5, further comprising generating a new functional component of the machine learning fabric, based on the added distribution monitoring component.
16. A method according to any preceding clause, wherein the first data point and/or the plurality of further data points are associated with a lithographic process.
17. A method according to any preceding clause, wherein the machine learning task comprises performing predictive maintenance associated with a lithographic process.
18. A method according to any preceding clause, wherein the machine learning task comprises a performance classification.
19. A method according to any preceding clause, wherein the data point has a missing value, and wherein the method further comprises:
   determining, based on the metric, a value to fill the missing value; and
   adding the determined value to the data point.
20. An apparatus comprising one or more processors and a non-transitory storage medium storing instructions which cause the one or more processors to control the apparatus to perform a method according to any of clauses 1 - 19.
21. An inspection apparatus comprising the apparatus of clause 20.
22. A metrology apparatus comprising the apparatus of clause 20.
23. A lithographic apparatus comprising the apparatus of clause 20.
24. A lithographic cell comprising the lithographic apparatus of clause 23.
25. A computer program product comprising instructions configured to, when executed on a suitable apparatus, adapt a distribution model of a machine learning fabric, the distribution model for mitigating the effect of concept drift, the distribution model configured to provide an output as input to a functional model of the machine learning fabric, the functional model for performing a machine learning task, the computer program configured to:
   obtain a first data point;
   provide the first data point as input to one or more distribution monitoring components of the distribution model, wherein the one or more distribution monitoring components have been trained on a plurality of further data points;
   determine, by at least one of the one or more distribution monitoring components, a metric representing a correspondence between the first data point and the plurality of further data points; and
   adapt the output of the distribution model based on the error metric.

The methods and systems described herein are set in a context of a lithographic process. However, the skilled person will understand that the system for detecting concept drift in a data set and informing one or more further models that use the data set as input to deal with the concept drift is suitable for other types of processes and applications.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

## Claims

1. A method for adapting a distribution model of a machine learning fabric, the distribution model for mitigating the effect of concept drift, the distribution model configured to provide an output as input to a functional model of the machine learning fabric, the functional model for performing a machine learning task, the method comprising:
obtaining a first data point;
providing the first data point as input to one or more distribution monitoring components of the distribution model, wherein the one or more distribution monitoring components have been trained on a plurality of further data points;
determining, by at least one of the one or more distribution monitoring components, a metric representing a correspondence between the first data point and the plurality of further data points; and
based on the error metric, adapting the output of the distribution model.

2. A method according to claim 1, wherein adapting the output of the distribution model comprises, if the metric determined by the at least one distribution monitoring component exceeds a drift threshold, generating a training distribution monitoring component associated with the data point.

3. A method according to claim 2, further comprising training the training distribution monitoring component on subsequent data points for which the metric determined by the at least one distribution monitoring component exceeds the drift threshold.

4. A method according to claim 3, further comprising adding the training distribution monitoring component to the one or more distribution monitoring components of the machine learning fabric after completion of the training.

5. A method according to any preceding claim, wherein adapting the output of the distribution model comprises, outputting a weighted combination of two or more distribution monitoring components.

6. A method according to claim 5, wherein the weighted combination comprises a weighted average inversely proportional to the metric of the two or more distribution monitoring components.

7. A method according to any preceding claim, wherein the output of the distribution model takes into account the distribution model output of one or more previous data points of the plurality of data points.

8. A method according to any preceding claim, wherein the distribution monitoring component comprises a machine learning algorithm that outputs a metric that reflects how well a data point matches a known data distribution associated with the distribution monitoring component.

9. A method according to any preceding claim, wherein the metric comprises a measure of a correlation between the first data point and a reconstruction of the first data point generated by the one or more distribution monitoring components.

10. A method according to claim 8 or 9, wherein the one or more distribution monitoring components comprise one or more of an autoencoder, a variational autoencoder, an isolation forest, a one-class support vector machine, and wherein the metric comprises a reconstruction error.

11. A method according to any preceding claim, wherein the functional model comprises one or more functional components, configured to undertake the machine learning task.

12. A method according to claim 11, wherein the one or more functional components are linked to the one or more distribution monitoring components, and wherein the output of the distribution model comprises an instruction of one or more functional components to be used when undertaking the machine learning task.

13. A method according to claim 11 or 12, wherein the output of the distribution model instructs the functional model to use a weighted combination of two or more functional components.

14. A method according to any of claims 11 to 13, when dependent on claim 5, further comprising generating a new functional component of the machine learning fabric, based on the added distribution monitoring component.

15. A method according to any preceding claim, wherein the data point has a missing value, and wherein the method further comprises:
determining, based on the metric, a value to fill the missing value; and
adding the determined value to the data point.
